(19)

**Europäisches Patentamt**
**European Patent Office**
**Office européen des brevets**

(11) **EP 4 381 919 B1**

(12) **EUROPEAN PATENT SPECIFICATION**

(45) Date of publication and mention
of the grant of the patent:
**23.04.2025 Bulletin 2025/17**

(21) Application number: **21762919.5**

(22) Date of filing: **06.08.2021**

(51) International Patent Classification (IPC):
*H10N 60/10* $^{(2023.01)}$     *G06N 10/40* $^{(2022.01)}$
*H10N 69/00* $^{(2023.01)}$     *H10N 60/01* $^{(2023.01)}$

(52) Cooperative Patent Classification (CPC):
**G06N 10/40; G06N 10/20; H10N 60/01;
H10N 60/128**

(86) International application number:
**PCT/US2021/045075**

(87) International publication number:
**WO 2023/014376 (09.02.2023 Gazette 2023/06)**

(54) **SEMICONDUCTOR-SUPERCONDUCTOR HYBRID DEVICE HAVING SIDE-JUNCTIONS**

HALBLEITER-SUPRALEITER-HYBRIDBAUELEMENT MIT SEITENÜBERGÄNGEN

DISPOSITIF HYBRIDE SEMI-CONDUCTEUR-SUPRACONDUCTEUR AYANT DES JONCTIONS
LATÉRALES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**12.06.2024 Bulletin 2024/24**

(73) Proprietor: **Microsoft Technology Licensing LLC
Redmond, WA 98052-6399 (US)**

(72) Inventors:
• **WINKLER, Georg Wolfgang
Redmond, Washington 98052-6399 (US)**
• **GAMBLE IV, John King
Redmond, Washington 98052-6399 (US)**
• **VAN HOOGDALEM, Kevin Alexander
Redmond, Washington 98052-6399 (US)**
• **KARIMI, Farhad
Redmond, Washington 98052-6399 (US)**
• **LUTCHYN, Roman Mykolayovych
Redmond, Washington 98052-6399 (US)**
• **MARCUS, Charles Masamed
Redmond, Washington 98052-6399 (US)**
• **VAITIEKENAS, Saulius
Redmond, Washington 98052-6399 (US)**
• **PÖSCHL, Andreas Simon
Redmond, Washington 98052-6399 (US)**

• **DANILENKO, Alisa
Redmond, Washington 98052-6399 (US)**
• **SABONIS, Deividas
Redmond, Washington 98052-6399 (US)**
• **O'FARRELL, Eoin Conor
Redmond, Washington 98052-6399 (US)**

(74) Representative: **Page White Farrer
Bedford House
21a John Street
London WC1N 2BF (GB)**

(56) References cited:
**WO-A1-2019/001753**

• JOUAN A ET AL: "Quantized conductance in a
one-dimensional ballistic oxide nanodevice",
ARXIV.ORG, CORNELL UNIVERSITY LIBRARY,
201 OLIN LIBRARY CORNELL UNIVERSITY
ITHACA, NY 14853, 28 March 2019 (2019-03-28),
XP081159380
• HART S ET AL: "Induced superconductivity in
the quantum spin Hall edge", NATURE PHYSICS,
NATURE PUBLISHING GROUP, LONDON, GB,
vol. 10, no. 9, 31 August 2014 (2014-08-31), pages
638 - 643, XP009520534, ISSN: 1745-2473, DOI:
10.1038/NPHYS3036

EP 4 381 919 B1

**Description**

Background

Semiconductor nanowires proximitized by a superconductor are expected to host a topological phase of matter, provided the right conditions. This makes them a promising candidate as building blocks of a fault-tolerant quantum computer. A concrete realization is provided by a semiconductor nanowire based on a two-dimensional electron gas ("2DEG") with proximity coupling to a conventional superconductor, which is typically grown as part of the epitaxial 2D wafer stack but can also be deposited after material growth during fabrication. This material platform has sizable spin-orbit coupling and large electron g-factor, key ingredients for the formation of a topological state. The 2D platform allows complex device geometries via top-down lithographic patterning involving etching and deposition.

The topological phase manifests itself in the form of a pair of Majorana zero modes (MZM) at the ends of the nanowire. Along the bulk of the nanowire, away from the ends, a gap in the single-electron spectrum is present. Experiments typically use tunneling spectroscopy at the ends of the nanowire to detect a zero-bias peak (ZBP) in tunneling conductance.

By forming a network of such nanowires and inducing the topological regime in parts of the network, it is possible to create a quantum bit which can be manipulated for the purpose of quantum computing. A quantum bit, also referred to as a qubit, is an element upon which a measurement with two possible outcomes can be performed, but which at any given time (when not being measured) can in fact be in a quantum superposition of the two states corresponding to the different outcomes.

To induce a topological phase, the device is cooled to a temperature where the superconductor (e.g. aluminum) exhibits superconducting behavior. The superconductor causes a proximity effect in the adjacent semiconductor, whereby a region of the semiconductor near the interface with the superconductor also exhibits superconducting properties, that is, a superconducting pairing gap is induced in the adjacent semiconductor. It is in this region of the semiconductor where the MZMs are formed when a magnetic field is applied to the device.

The role of the magnetic field is to lift the spin degeneracy in the semiconductor. Degeneracy in the context of a quantum system refers to the case where different quantum states have the same energy level. Lifting the degeneracy means causing such states to adopt different energy levels. Spin degeneracy refers to the case where different spin states have the same energy level. Spin degeneracy can be lifted by means of a magnetic field, causing an energy level spilt between the differently spin-polarized electrons. This is known as the Zeeman effect. The Zeeman energy, i.e. the magnitude of the energy level split, should be at least as large as the superconducting gap in order to close the trivial superconducting gap and reopen a topological gap in the system.

Inducing MZMs typically also requires adjusting the electrostatic potential of charge carriers in the nanowire by gating the nanowire with an electrostatic potential. The electrostatic potential is applied using a gate electrode. Applying an electrostatic potential manipulates the number of charge carriers in the conductance band or valence band of the semiconductor component.

There is a need to characterize the electronic properties of semiconductor-superconductor hybrid systems. Non-local conductance measurements are of particular interest. A non-local conductance is a conductance through two terminals of a nanowire, as opposed to a local conductance measurement where conductance is measured between the superconductor component and one terminal of the semiconductor component.

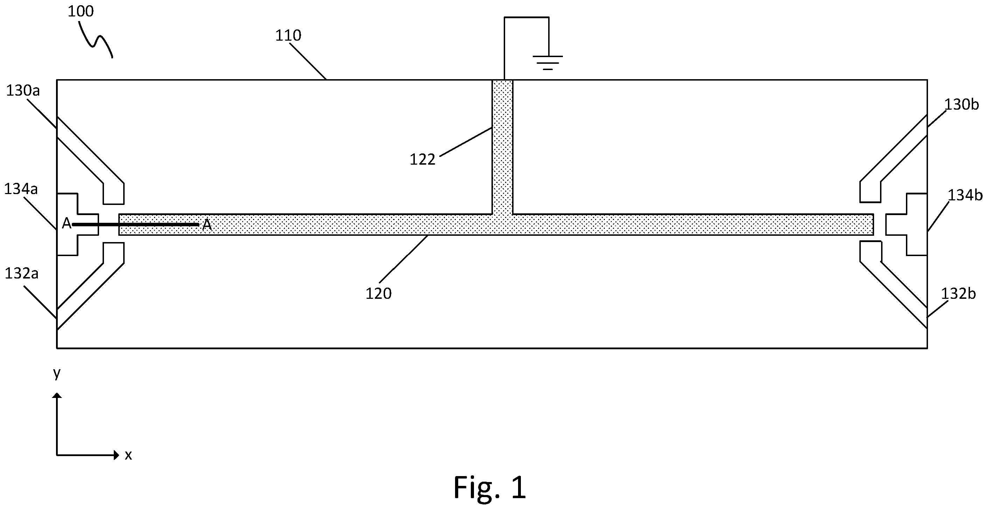

A schematic plan view of a comparative system 100 used for measuring non-local conductance illustrated in Fig. 1. The system 100 includes a semiconductor heterostructure 110 configured to host a 2DEG. A superconductor component 120 is arranged over the semiconductor heterostructure 110. The superconductor component 120 is T-shaped and includes an elongate strip portion which extends in a length direction x, and a branch 122 which extends in a width direction y. Branch 122 is connected to electrical ground.

A gate stack is arranged over the device. The gate stack depletes charge carriers selectively from regions of the semiconductor heterostructure which are not under the superconductor component. This defines a channel region underneath the superconductor component. A channel region is an active part of a semiconductor component, through which current may flow.

Junctions are arranged at the ends of the elongate strip portion of the superconductor component 120. Each junction includes a set of electrodes 130, 132, 134. The electrode 134 is operated to induce a normally conductive region, referred to as a lead, in the region of the semiconductor component underneath electrode 134. Then, by applying gate voltages to the electrodes 130, 132 tunnelling of electrons between the active region and the lead under electrode 134 is made possible. The non-local conductance may be determined based on measurements of the tunnelling current.

WO 2019/001753 A1 discloses the fabrication of a mixed semiconductor-superconductor platform in phases. In a masking phase, a dielectric mask is formed on a substrate, such that the dielectric mask leaves one or more regions of the substrate exposed. In a selective area growth phase, a semiconductor material is selectively grown on the substrate in the one or more exposed regions. In a superconductor growth phase, a layer of superconducting material is formed, at least part of which is in direct contact with the selectively grown semiconductor material. The mixed semiconductor- superconductor platform comprises the selectively grown semiconductor material and the superconducting material in direct contact with the selectively grown semiconductor material.

Hart et al (Nature Physics, vol. 10, pp. 638-643, 2014) discloses measurements of superconductivity induced in two-dimensional HgTe/HgCdTe quantum wells.

Jouan et al (arXiv: 1903.12134v1 [cond-mat.mes-hall]) discloses the quantization of conductance in a ballistic quantum point contact by electrostatic confinement of a 2-dimensional electron gas at an $LaAlO_3/SrTiO_3$ interface using a split-gate.

Summary

In one aspect, the present invention provides a semiconductor-superconductor hybrid device according to claim 1. The semiconductor-superconductor hybrid device comprises a semiconductor component configured to host a 2-dimensional electron gas or a 2-dimensional hole gas; a superconductor component arranged over the semiconductor component, the superconductor component being capable of inducing superconductivity in a channel region of the semiconductor component by proximity effect; and a set of depletion gates arranged over the semiconductor component, the set of depletion gates being configured to define boundaries of the channel region by depleting charge carriers from regions of the semiconductor component around the perimeter of the channel region. The superconductor component comprises an elongate strip of superconductor material having two ends, at least one of the ends being electrically grounded. The set of depletion gates comprises at least one first outer depletion gate for defining a first outer segment of the channel region; at least one second outer depletion gate for defining a second outer segment of the channel region; and at least one inner depletion gate for defining an inner segment of the channel region between the first outer segment and the second inner segment. The device further comprises a first junction comprising a first space between the at least one first outer depletion gate and the at least one inner depletion gate, and a first helper gate for gating the first space; and a second junction comprising a second space between the at least one second outer depletion gate and the at least one inner depletion gate, and a second helper gate for gating the second space. The first and second helper gates are each operable to connect electrically the channel region to respective leads.

In another aspect, the present invention provides a method of operating the semiconductor-superconductor hybrid device according to claim 14. The method comprises cooling the device to a temperature at which the superconductor component is superconductive; applying gate voltages to the set of depletion gates to define the channel region by depleting charge carriers from regions of the semiconductor component along edges of the channel region; applying a magnetic field to at least the channel region of the semiconductor component; and applying gate voltages to the helper gates to connect electrically the channel region to the leads.

Certain more specific aspects of the invention are set out in the dependent claims.

Brief Description of the Drawings

To assist understanding of embodiments of the present invention and to show how such embodiments may be put into effect, reference is made, by way of example only, to the accompanying drawings in which:

Fig. 1 is a schematic plan view of a semiconductor-superconductor hybrid device according to a comparative example;
Fig. 2 is a schematic plan view of a first example of a semiconductor-superconductor hybrid device;
Fig. 3 is a schematic cross-section along the line B ... B of Fig. 2;
Fig. 4 is a schematic plan view of a second example of a semiconductor-superconductor hybrid device;
Fig. 5 is a schematic plan view of an example side junction;
Fig. 6 is a plot showing a simulation of electrical potential as a function of position along line A...A in a device of the type shown in Fig. 1;
Fig. 7 is a plot showing a simulation of electrical potential as a function of position along line C...C in a device of the type shown in Fig. 4;
Fig. 8 is a heat map showing results of a simulation of the local density of states as a function of energy and position in a device of the type shown in Fig. 1;
Fig. 9 is a heat map showing results of a simulation of the local density of states as a function of energy and position in a device of the type shown in Fig. 2; and

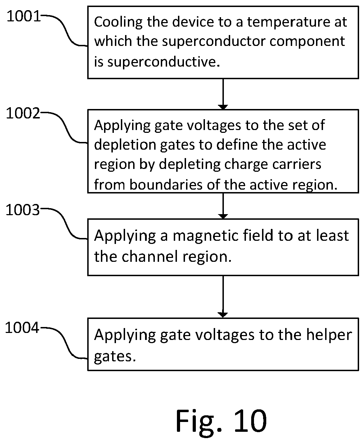

Fig. 10 is a flowchart outlining a method of operating a semiconductor-superconductor hybrid device of the type described herein.

Detailed Description

As used herein, the verb 'to comprise' is used as shorthand for 'to include or to consist of'. In other words, although the verb 'to comprise' is intended to be an open term, the replacement of this term with the closed term 'to consist of' is explicitly contemplated, particularly where used in connection with chemical compositions.

Directional terms such as "top", "bottom", "left", "right", "above", "below", "horizontal" and "vertical" are used herein for convenience of description and relate to the orientation shown in the relevant drawing. For the avoidance of any doubt, the use of this terminology is not intended to limit the orientation of the device in an external frame of reference.

As used herein, the term "superconductor" refers to a material which becomes superconductive when cooled to a temperature below a critical temperature, $T_c$, of the material. The use of this term is not intended to limit the temperature of the device.

A "nanowire" is an elongate member having a nano-scale width, and a length-to-width ratio of at least 10, optionally at least 100, or at least 500, or at least 1000. A typical example of a nanowire has a width in the range 10 to 500 nm, optionally 50 to 100 nm or 75 to 125 nm. Lengths are typically of the order of micrometres, e.g. at least 1 $\mu$m, or at least 10 $\mu$m. The channel regions of devices as described herein are typically in the form of nanowires, with the edges of the nanowires being defined electrostatically through the use of gate electrodes.

The abbreviation "2DEG" stands for 'two-dimensional electron gas'. "2DHG" stands for 'two-dimensional hole gas'.

A "semiconductor-superconductor hybrid structure" comprises a semiconductor component and a superconductor component which is configured to induce superconductivity in the semiconductor component by proximity effect. In particular, this term refers to a structure capable of showing topological behaviour such as Majorana zero modes, or other excitations useful for quantum computing. The operating conditions generally comprise cooling the structure to a temperature below the Tc of the superconductor component, applying a magnetic field to the structure, and applying electrostatic gating to the structure.

It has been found that detecting topological behavior using devices of the type shown in Fig. 1 is difficult. Provided herein are devices which may allow measurements on topological phases to be performed more easily.

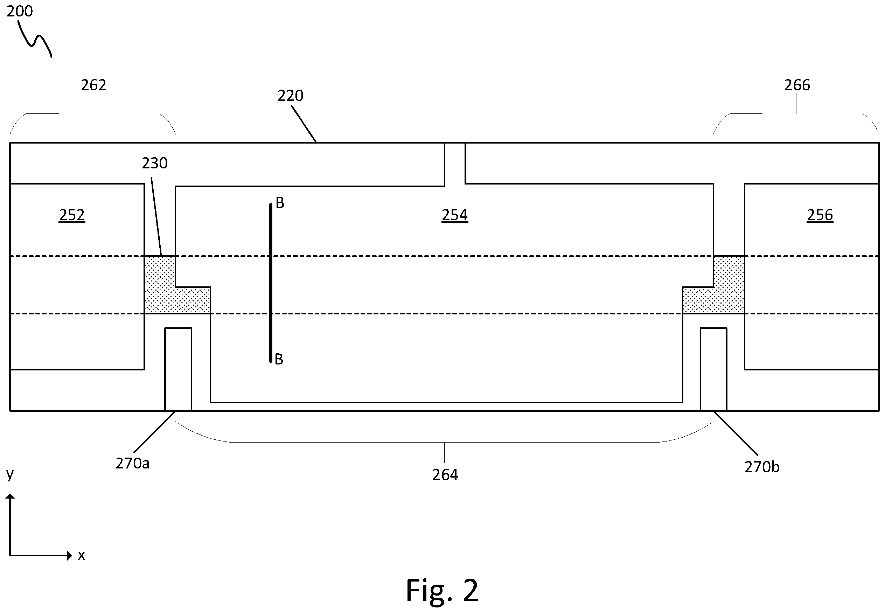

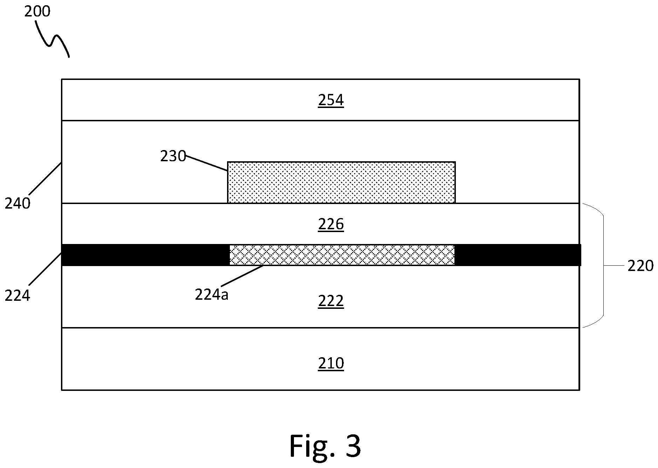

A first example of a semiconductor-superconductor hybrid device will now be explained with reference to Figs. 2 and 3. Fig. 2 is a schematic plan view of the device. Fig. 3 is a schematic cross-section along line A...A of Fig. 2.

The device 200 includes a semiconductor component 220, a superconductor component 230, a set of depletion gates 252, 254, 256 with junctions between adjacent ones of the depletion gates, and helper gates 270a, 270b for gating the junctions.

The semiconductor component 220 is in the form of a semiconductor heterostructure. The semiconductor heterostructure comprises a quantum well 224 arranged between a lower barrier 222 and an upper barrier 226. This structure is referred to as a heterostructure because the quantum well comprises a material which is different from the material(s) of the lower barrier and upper barrier. The materials of the lower barrier and the upper barrier may each be independently selected.

The configuration of the lower and upper barriers 222, 226 is not particularly limited, provided that these layers allow charge carriers, i.e. electrons or holes, to be trapped in the quantum well 224. The lower barrier 222 may comprise one or more layers of one or more different materials. The upper barrier 226 may comprise one or more layers of one or more different materials. Constructing a barrier from a plurality of layers may provide defect filtering, i.e. may reduce the effects of dislocations in the crystalline structure of the materials used.

Quantum well layer 224 may comprise a layer of semiconductor material which has a relatively small band gap compared to the materials of the lower and upper barriers 222, 226. The quality of a topological phase in a hybrid device is strongly dependent upon the degree of coupling between the semiconductor component and the superconductor component. Upper barrier 226 may also be used to tune the coupling between the superconductor and the 2DEG in the quantum well, as explained in US 2021/126181 A1.

Illustrative materials useful for forming quantum wells are described in, for example, Odoh and Njapba, "A Review of Semiconductor Quantum Well Devices", Advances in Physics Theories and Applications, vol. 46, 2015, pp. 26-32; and S. Kasap, P. Capper (Eds.), "Springer Handbook of Electronic and Photonic Materials", DOI 10.1007/978-3-319-48933-9_40.

In particular, the semiconductor heterostructure may comprise III-V semiconductor materials. The III-V semiconductor materials may be compounds or alloys each comprising at least one group III element selected from indium, aluminum, and gallium; and at least one group V element selected from arsenic, phosphorous, and antimony. The materials of the heterostructure may, for example, each independently comprise materials of Formula 1:

$$Al_xIn_yGa_zAs$$

wherein values of x, y and z are independently selected, and are the range 0 to 1. x, y and z may sum to 1. Examples of particularly useful materials include indium arsenide, aluminum indium arsenide, indium gallium arsenide, aluminum gallium arsenide, and aluminum indium gallium arsenide. As will be appreciated, electronic properties of the materials of the heterostructure may be controlled by varying their composition and stoichiometry.

The use of other classes of semiconductor materials is also contemplated. For example, the heterostructure may comprise II-VI semiconductor materials. Examples of II-VI semiconductor materials include cadmium telluride, mercury telluride, lead telluride and tin telluride. The heterostructure may comprise group IV semiconductor materials. For example, the heterostructure may comprise silicon, germanium, and/or silicon-germanium alloys. Heterostructures comprising group IV semiconductor materials may host 2DHGs.

In operation, charge is localized in the quantum well 224. More specifically, quantum well 224 may host a 2DEG or 2DHG. The 2DEG or 2DHG may then be further constrained to a channel region 224a through the use of the depletion gates, which will be discussed in more detail below. The channel region 224a may be in the form of a nanowire arranged under the superconductor component 230. Excitations of interest, such as Majorana zero modes, may be generated in such a nanowire.

Fig. 3 further illustrates that the device 200 is arranged on a substrate 210. The substrate may be any structure on which the device is to be constructed. The substrate typically comprises a wafer, i.e. a piece of single crystalline material. Examples of wafer materials include indium phosphide, gallium arsenide, indium antimonide, indium arsenide, and silicon. The substrate may be a more elaborate workpiece, further comprising additional structures arranged on or over the wafer. The substrate may include layers of two or more materials.

The superconductor component 230 is arranged over the semiconductor component 220. An optional dielectric may be present between the semiconductor component 220 and the superconductor component 230. The superconductor component 230 is in the form of an elongate strip extending in a length direction, x.

The superconductor component 230 may have a width of less than or equal to 250 nm, optionally 40 to 60 nm, further optionally 45 to 55 nm.

The superconductor component extends along the lengths of the inner and outer segments of the device, discussed below.

The superconductor component 230 is linear and unbranched. One end of the superconductor component is connected to ground, e.g., connected to a ground plane or to external grounding via a contact pad. The other end may optionally also be connected to ground.

The material used to form the superconductor component may be selected as appropriate. The superconductor is typically an s-wave superconductor. Any of the various s-wave superconductors known the art may be used. Examples include aluminum, indium, tin, and lead, with aluminum being preferred in some contexts. In implementations where aluminum is used, the superconductor component 230 may for example have a thickness in the range 2 to 10 nm.

A dielectric 240 covers the superconductor component 230. Examples of materials useful as dielectrics include silicon oxides ($SiO_x$), silicon nitrites ($SiN_x$), aluminum oxides ($AlO_x$), and hafnium oxides ($HfO_x$).

The device 200 further includes a set of depletion gates 252, 254, 256. The depletion gates comprise first and second outer depletion gates 252, 256 with an inner depletion gate 254 arranged therebetween. The depletion gates may be fabricated from any appropriate conductive material, typically a normally-conductive metal such as gold or titanium.

The depletion gates 252, 254, 256 overlap the superconductor component 230, and are separated from the superconductor component 230 by the dielectric 240.

When in use, voltages are applied to the depletion gates, the voltages being selected to deplete charge carriers from corresponding regions of the semiconductor component 220. The superconductor 230 screens a part of the semiconductor component 220 from the electrostatic field. The depletion gates and superconductor component thus together define boundaries of channel region 224a of the semiconductor component 220. The voltages which are applied to individual ones of the depletion gates may be independently selected. This may allow different parts of the active region to be tuned to different electrical potentials.

A single depletion gate which defines two edges of an active region may be referred to as a "joined gate". Depletion gates 252, 254, 256 of device 200 are each joined gates.

A respective space is provided between the inner depletion gate 254 and each of the two outer depletion gates 252, 256, thereby forming junctions. The junctions divide the channel region 224a into an inner segment in inner part 264 of the device, and outer segments in outer parts 262, 266 respectively. In use, the inner segment may be tuned to a topological regime and the outer segments may be tuned to trivial regimes. The inner segment may be referred to as a "wire", and the length of the inner segment may be referred to as the "wire length".

The length of the inner segment may be in the range 1 to 50 $\mu$m, optionally 2 to 3 $\mu$m, further optionally 2.4 to 2.6 $\mu$m.

The outer segments may be selected to have lengths which are greater than a maximum superconducting coherence length (also referred to herein as a "maximum coherence length") of the system. The maximum coherence length $\xi$ may be calculated using

Equation 1:

$$\xi = \frac{\hbar v_f}{\pi \Delta}$$

where $\hbar$ is the reduced Planck constant, $v_f$ is the Fermi velocity, and $\Delta$ is the induced superconducting energy gap.

For example, the outer segments may have lengths of at least 5 times greater than the maximum coherence length of the system. By way of illustration, each outer segment may have a length of at least 2 $\mu$m. Often, each outer segment has a length which is equal to that of the inner segment.

By providing outer segments which have lengths greater than the system's maximum coherence length and tuning these regions to a trivial regime, a filtering effect may be obtained. The outer segments may act as quasiparticle filters between the inner segment 264 and the connections to ground. In other words, the trivial regions separate the topological segment of the wire 264 from the connections to ground. The connections to ground may otherwise introduce quasiparticles into the topological segment 264 which can destroy the topological phase.

Each junction is provided with a respective helper gate 270a, 270b. In use, voltages are applied to the helper gates to tune corresponding regions of the semiconductor component to a conductive regime. In this example, the helper gates cause corresponding parts of the semiconductor component to act as normally-conductive leads. An electrical connection between the leads and the channel region 224a is also formed. Measurements of non-local conductance through the channel may therefore be performed by measuring the current through the leads. It has been found that the use of such helper gates may allow for connection to the channel with very little disruption to electrical potentials in the channel.

The leads may be connected to appropriate amplifier circuits to allow for measurement of the current. For example, the leads may extend to contact pads, and may be coupled to amplifier circuits via wire bonds or the like attached to the contact pads. The amplifier circuit may be a current-to-voltage convertor. An example of a suitable amplifier is the SP938c current-to-voltage convertor available from Basel Precision Instruments.

Since the leads are arranged to the sides of the nanowire, rather than at ends of the nanowire as in the comparative example, the leads may allow for better coupling to low-momentum states, in other words, low-momentum electrons may be detected more easily. This is useful because the topological phase is formed by the lowest momentum modes in a multi-mode wire. Further, since the superconductor component is connected to ground at its end rather than via a branch, the presence of additional states in the bulk of the nanowire between the Majorana zero modes may be avoided.

In implementations where the semiconductor-superconductor hybrid device is a component of a qubit device, the ability to perform measurements on hybrid device may be useful for e.g. tuning the qubit.

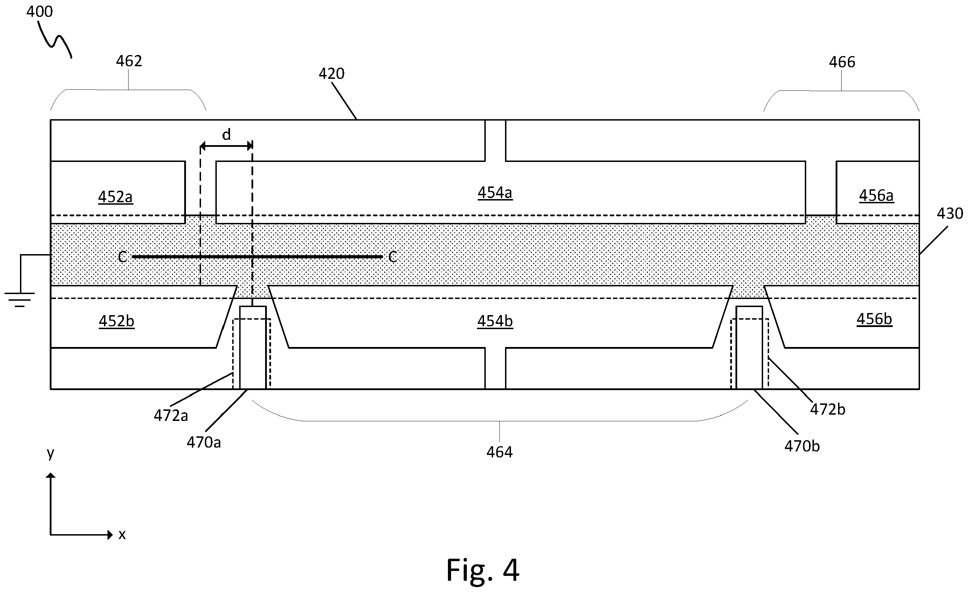

A second example of a semiconductor-superconductor hybrid device 400 will now be described with reference to Fig. 4. Device 400 has a different arrangement of depletion gates and a different junction configuration, and includes metal leads rather than semiconductor leads. Device 200 may itself be modified to include metal leads. Metal leads may be particularly useful in device 200 since device 200 includes fewer gates for tuning the junction.

Device 400 includes a semiconductor component 420, a superconductor component 430, and a set of depletion gates 452, 454, 456. A dielectric is present over the superconductor component 430, and the set of depletion gates is arranged over the dielectric.

The semiconductor component and superconductor component are as previously described with reference to device 200.

Device 400 differs from device 200 in that the depletion gates are each split gates. By 'split gate' is meant a pair of spaced-apart electrodes which are arranged on opposite sides of the active region of the device. Each electrode of the pair may be operated independently.

The depletion gates comprise a first outer pair of depletion gates 452a, 452b, an inner pair of depletion gates 454a, 454b, and a second outer pair of depletion gates 456a, 456b. The pairs of depletion gates are operable to define and tune the channel region in first outer segment 462, inner segment 464, and second outer segment 466, respectively. Since each individual depletion gate may be operated independently, this may allow for finer control over potentials in the active region and junction regions compared to device 200, which has a single depletion gate for each segment of the channel region.

As previously described with reference to the first example, in operation, the outer segments may be tuned to trivial regimes and the inner segment may be tuned to a topological regime. The lengths of the outer segments may be selected to be greater than a maximum coherence length of the system.

The edges of the split depletion gates in this example overlap the superconductor component, with a space being provided between each pair of split gates. Providing an overlap is useful since this allows the edge of the active region to be defined easily by the superconductor component: the superconductor component screens the active region from the electrostatic field applied by the depletion gates. In variants, the overlap may in principle be omitted but this may make it more difficult to operate the device.

Considering the left-hand junction shown in Fig. 4, it may be seen that the junction includes a first space between outer gate 452a and inner gate 454a, and a second space between outer gate 452b and inner gate 454b.

The helper gate 470a for the left-hand junction is configured to gate the semiconductor component in the region of the second space. The conductive connective region which is induced by helper gate 470a extends between outer gate 452b and inner gate 454b. Thus, by applying gate voltages to gates 452b and 454b, the properties of the connection may be modified. This may allow for control over the degree of coupling between the channel region and the lead. Gates 452a and 452b, on the opposite side of the active region, are operable to control chemical potential in the bulk of the channel region separately from that in the connective region. In other words, the use of split gates may allow for adjustment of the properties of the junction partly independently of the properties of the bulk of the channel region.

In this example, a left metal lead 472a is arranged under the helper gate 470a for the left-hand junction, and a right metal lead 472b is arranged under the helper gate 470b for the right-hand junction. The use of metal leads is an alternative to the use of semiconductor tuned to a normally-conductive regime as in the first example. The metal leads may be coplanar with superconductor component 430, and may be fabricated from superconductor material simultaneously with superconductor component 430. The leads 472a, 472b are separated from the respective helper gates by dielectric 240. The use of metal leads may allow the helper gate voltage to be chosen more freely during operation of the device, since there is no need for the helper gate to induce a conductive channel in the semiconductor component when a metal lead is present.

Depending upon the orientation of the magnetic field during operation of the device, metal leads 472a and 472b may be normally-conductive as opposed to superconductive during operation of the device, due to anisotropy of the critical magnetic field for superconductor components. For example, a magnetic field may be applied parallel to the length of the superconductor component 430, and the leads may extend perpendicular to the superconductor component 430. It is useful for the leads to be normally-conductive during operation of the device, since this allows for conductance spectroscopy measurements of Majorana zero modes.

The junctions in the Fig. 4 device are offset junctions. Referring to the left-hand junction, the first and second spaces are laterally offset from one another by a distance d. The distance d is measured from the midpoint of the first space to the midpoint of the second space in the x direction. The offset d may be selected as appropriate. For example, the offset may be in the range 100 to 500 nm, optionally 180 to 220 nm, further optionally 200 nm.

By providing a junction having an offset, inhomogeneity of electrical potential at the junction may be reduced. Inhomogeneous electrical potentials may induce localized states which can add noise and make it more difficult to measure a topological signal. This may allow for easier detection of topological states

Various modifications may be made to the illustrated devices.

In the illustrated devices, the metal leads 472 are arranged directly on the semiconductor component. In variants, a dielectric may be present between the semiconductor component and the metal leads. Such a dielectric is useful where the superconductor component would otherwise form an Ohmic, as opposed to Schottky, contact with the semiconductor component.

The superconductor components of the illustrated devices each connect to ground at one end. In variants, both ends of the superconductor component may be connected to ground.

In device 200, all of the depletion gates are joined gates, and in device 400 all of the depletion gates are split gates. Devices which include a combination of joined and split gates are also contemplated. For example, the outer depletion gates may each be joined gates and the inner depletion gate may be a split gate.

In devices which include split gates, the inclusion of an offset is optional. The spaces between electrodes on opposite sides of the channel region may be aligned with one another.

The illustrated devices each have two junctions. Devices which include three or more junctions are also contemplated. For example, some variants may have a further junction in a topological segment. Some variants may have a plurality of topological segments, separated by trivial segments.

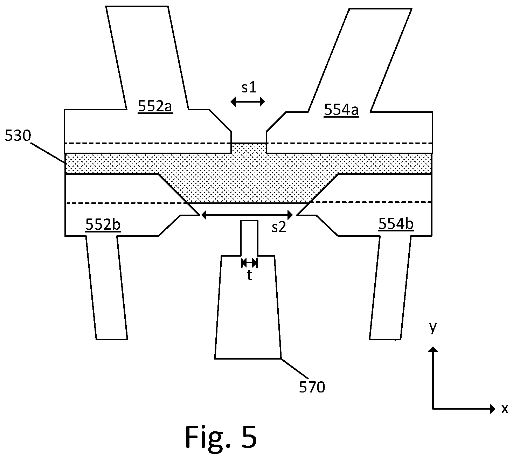

Various junction configurations may be used. One example is illustrated in Fig. 5.

Fig. 5 shows a junction between a pair of outer depletion gates 552a, 552a and a pair of inner depletion gates 554a, 554b arranged relative to a superconductor component 530.

The junction includes a first space s1 between outer depletion gate 552a and inner depletion gate 554a, and a second space s2 between outer depletion gate 552b and inner depletion gate 554b. A helper gate 570 is arranged between outer depletion gate 552b and inner depletion gate 554b, and extends into the second space s2.

The size of a space between two adjacent depletion gates may be measured as the shortest distance between the depletion gates in the x direction.

The size of the first space s1 is not particularly limited and may be selected as appropriate provided that inner and outer depletion gates 552a, 554b are electrically isolated from one another. It may be desirable for space S1 to be as narrow as possible.

The size of second space s2 is not particularly limited, provided that there is space for helper gate 570. In this example, the space s2 is in the range 100 to 200 nm, optionally 140 to 160 nm.

The helper gate 570 of this example is configured to provide a quantum point contact between the lead of the device and the channel of the device. A quantum point contact is an electrostatic potential containing a saddle point. Desirably, the quantum point contact is as close as possible to the channel without disturbing the electrostatics of the channel.

The helper gate 570 includes a tip which is arranged close to the channel. The tip of the helper gate provides the quantum point contact and allows for tuning of the connecting region. The tip in this example has a width in the range 25 to 15 nm, optionally 30 to 40 nm.

The helper gate of this example also includes a body which extends away from the tip. The body is typically wider than the tip, and may have a width of at least 80 nm, for example. In this example, the lead is a region of the semiconductor component which, when in use, is tuned to a conductive regime using the helper gate. The body is used to define this region. The region under the body may also act as a reservoir of charge carriers which may act as a normally-conductive lead.

Fig. 5 further illustrates that the depletion gates may be configured to reduce the effects of misalignment during fabrication. Semiconductor-superconductor hybrid devices are typically fabricated by building up layers of the device. Superconductor components and the electrodes are often fabricated using lithography. Misalignment of the lithographic masks used to fabricate the superconductor component and electrodes can sometimes occur.

To reduce the effects of misalignment, the depletion gates are provided with chamfered edges extending in the y-direction. The chamfered edges of adjacent electrodes are angled away from one another. The angle of the chamfer may be about 45°. In this way, the point at which the spacing between the electrodes is narrowest will be close to the nanowire even if there is a small misalignment between mask used to define the nanowire and the mask used to define the gates.

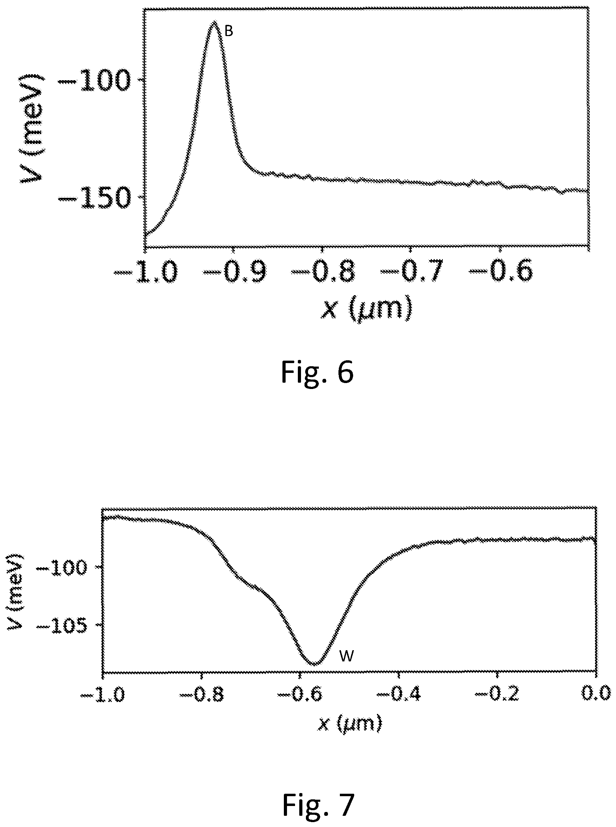

One effect of arranging the leads at the side of the channel may be understood from Figs. 6 and 7.

Fig. 6 is a plot showing the results of a simulation of electrical potential as a function of position along line A...A in a comparative device of the type shown in Fig. 1. In such a device, a potential barrier B is present between the superconductor component 120 and the lead 134.

Fig. 7 is a plot showing the results of a simulation of electrical potential as a function of position along line C...C in a device of the type illustrated in Fig. 4. A potential well W is present at the junction.

The difference in the potential profiles influences what can be detected using the two types of device.

In the channel of a semiconductor-superconductor hybrid device, electrons may occupy either high-momentum states or low-momentum states. The detection of low-momentum electrons is particularly relevant because this may allow for identification of the presence of Majorana zero modes.

In a multi-mode wire, the topological mode is formed in the sub-band with the lowest velocity in the x-direction of the wire (the lowest momentum $k\_x$). The topological mode also has the highest velocity in the y-direction of the wire (highest momentum $k\_y$).

Modes with higher momentum $k\_x$ are in trivial states, and have a larger velocity in x-direction. A large velocity in the x-direction helps in overcoming potential barrier B. A low barrier, or a potential well W, in the x direction is advantageous to measure low momentum modes. This can be achieved with leads arranged to the sides. The large velocity in y-direction of low momentum modes helps in overcoming a potential barrier into the leads from the sides.

Consequently, high-momentum electrons are able to overcome or tunnel through potential barrier B, whereas low-momentum electrons are not. Therefore, whilst trivial states can be measured using the comparative device, detection of low-momentum electrons which may be in topological states is difficult.

For devices with leads arranged to the sides of the nanowire, low-momentum states may be more easily detected, by virtue of their relatively large $k\_y$.

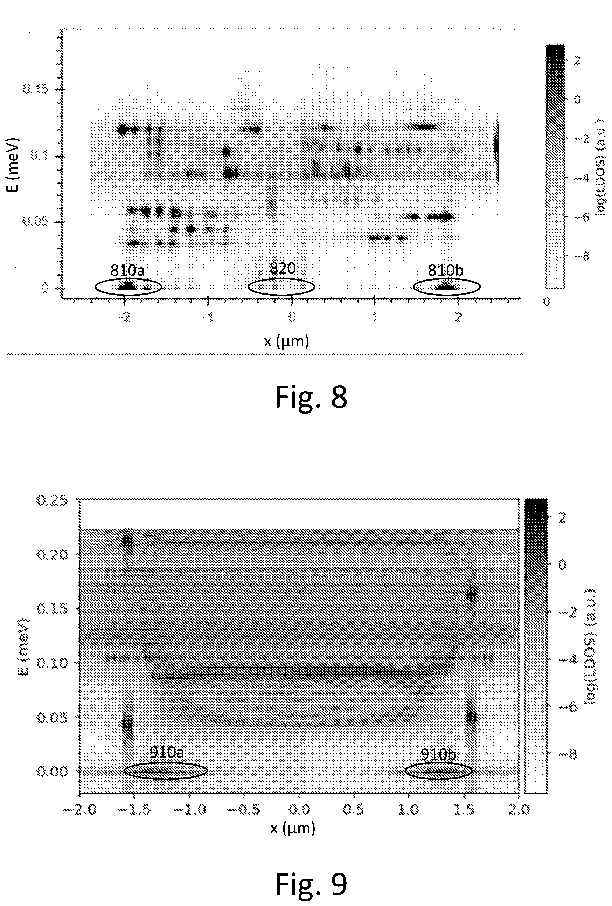

Effects associated with the use of a linear superconductor component connected to ground through its ends may be understood from Figs. 8 and 9.

Fig. 8 is a heat map showing the results of a simulation of the local density of states as a function of energy and position in a comparative device of the type shown in Fig. 1. The states which are of particular interest are those at $E \approx 0$. Majorana zero modes would be at $E \approx 0$, and would exist in pairs, at the ends of the nanowire. The states at 810a and 810b are consistent with the present of Majorana zero modes.

In Fig. 8, additional states are present in region 820, between the possible MZMs. This region corresponds to the position of the branch 122 of the 'T', where the superconductor component connects to ground. The presence of these additional states shows that the branch disrupts the topological phase behavior: an ideal topological system would have a gap in the single-electron spectrum along the bulk of the channel, and this is not the case for in Fig. 8.

Fig. 9 is a heat map showing the results of a simulation of the local density of states as a function of energy and position in a device according to the present invention.

As may be seen, states which are consistent with Majorana zero modes are present in regions 910a, 910b. The additional states toward the middle of the channel which were present in the comparative case are absent. This illustrates that grounding the superconductor component at its ends, rather than through a branch, may avoid disruption to the topological phase.

A method of operating the semiconductor-superconductor devices as described herein will now be described with reference to Fig 9. Fig. 9 is a flow diagram outlining the method.

At block 1001, the device is cooled to a temperature at which the superconductor component is superconductive. Typically, the device is operated at a temperature of less than 1 K. Various suitable cryogenic systems, e.g. dilution refrigerators, have been described. The device is maintained at its operating temperature during operation.

At block 1002, gate voltages are applied to the set of depletion gates so as to define the active region by depleting charge carries from boundaries of the channel region.

At block 1003, a magnetic field is applied to at least the channel region of the semiconductor component. The magnetic field generally includes a component applied in the x direction, i.e. parallel to the nanowire. The magnetic field may have a field strength of the order of 1 to 2 T. The magnetic field lifts spin degeneracy in the device, in other words, causing different spin states which, in the absence of an applied field, have equal energy to have different energies.

At block 1004, gate voltages are applied to the helper gates. The gate voltages applied to the helper gates form electrical connections between the channel region and respective leads.

As will be appreciated, the operations of blocks 1002, 1003, and 1004 overlap in time. When the magnetic field is applied, the gate voltages applied to the depletion gates may be selected to tune outer segments of the channel to trivial regimes, and the inner segment of the channel to the topological regime.

The leads may be metal leads. Alternatively, the leads may be regions of the semiconductor component which are tuned to act as normal conductors by the gate voltages applied to the helper gates.

The method may further comprise measuring a current through the leads.

It will be appreciated that the above embodiments have been described by way of example only.

More generally, there is provided a semiconductor-superconductor hybrid device according to claim 1. The semiconductor-superconductor hybrid device comprises a semiconductor component configured to host a 2-dimensional electron gas or a 2-dimensional hole gas; a superconductor component arranged over the semiconductor component, the superconductor component being capable of inducing superconductivity in a channel region of the semiconductor component by proximity effect; and a set of depletion gates arranged over the semiconductor component. The set of depletion gates is configured to define boundaries of the channel region by depleting charge carriers from regions of the semiconductor component along edges of the channel region. The superconductor component comprises an elongate strip of superconductor material having two ends, at least one of the ends being electrically grounded. The set of depletion gates comprises at least one first outer depletion gate for defining a first outer segment of the channel region; at least one second outer depletion gate for defining a second outer segment of the channel region; and at least one inner depletion gate for defining an inner segment of the channel region between the first outer segment and the second inner segment. The device further comprises a first junction comprising a first space between the at least one first outer depletion gate and the at least one inner depletion gate, and a first helper gate for gating the first space; and a second junction comprising a second space between the at least one second outer depletion gate and the at least one inner depletion gate, and a second helper gate for gating the second space. The first and second helper gates are each operable to connect electrically the channel region to respective leads.

The channel region may be in the form of a nanowire.

The outer depletion gates may be configured to tune the outer segments to trivial regimes. The at least one inner depletion gate may be configured to tune the inner segment to a topological regime. Tuning the outer segments of the channel to trivial regimes may provide a filtering effect, thereby protecting the inner segment's topological phase. The trivial end segments separate the inner segment (topological wire segment) from the connections to ground. The connections to ground may otherwise compromise the topological phase.

The first outer segment and the second outer segment may each have lengths which are greater than or equal to a maximum superconducting coherence length of the semiconductor-superconductor hybrid device. For example, the first outer segment and the second outer segment may each have lengths which are at least 5 times greater than the superconducting coherence length of the device. The first outer segment and the second outer segment may each have lengths which are equal to the length of the inner segment. The maximum superconducting coherence length is calculated in accordance with Equation 1 as set out hereinabove.

For example, the first and second outer segments may each have lengths of at least 2 $\mu$m.

The length of the inner segment may be in the range 1 to 50 $\mu$m, optionally 2 to 3 $\mu$m, further optionally 2.4 to 2.6 $\mu$m. The first and/or second outer segments may have lengths equal to the length of the inner segment.

Both ends of the superconductor component may be electrically grounded.

The superconductor component may consist essentially of the elongate strip. In such implementations, the superconductor component may be formed integrally with one or more contact pads for connecting the superconductor to ground, and/or one or more superconductive ground planes.

The superconductor component may have a width of less than or equal to 250 nm, optionally 40 to 60 nm, further optionally 45 to 55 nm.

The elongate strip may be unbranched. This may allow topological behavior to be induced more easily. The elongate strip is typically linear.

The semiconductor-superconductor hybrid device may further comprise a dielectric arranged between the set of depletion gates and the superconductor component. A dielectric may be useful in some implementations for preventing flow of current between the superconductor component and the depletion gates.

The at least one inner depletion gate may be a single depletion gate. In such implementations, the inner depletion gate extends over the superconductor component, such that the superconductor component screens the inner segment from the inner depletion gate.

In alternative implementations, the at least one inner depletion gate is a pair of opposed depletion gates, each depletion gate of the pair being arranged along a respective edge of the inner segment. Pairs of opposed depletion gates are also referred to herein as "split gates". The use of split gates may allow for a greater degree of control over potentials in the channel region.

The at least one first and/or at least one second outer depletion gates may be pairs of opposed depletion gates. In particular, the first and second outer depletion gates may each be pairs of opposed depletion gates.

In implementations which include one or more split gates, a space between two adjacent depletion gates on a first side of the channel region is laterally offset from a space between two adjacent depletion gates on a second side of the channel region opposite the first side. In other words, one or more of the junctions may be an offset junction. Offset junctions may reduce the number of resonances in the device.

The leads may be regions of the semiconductor component, with the helper gates being configured to tune the leads to a normally-conductive state.

Alternatively, the leads may be metal leads. In such implementations, the nature of the metal is not particularly limited. For example, the metal may be a superconductor material; in such implementations, the leads and superconductor component may be fabricated simultaneously.

The semiconductor component is typically a heterostructure comprising a quantum well arranged between upper and lower barriers.

The helper gates may be configured to provide quantum point contacts between the leads and the channel region. In particular, the helper gates may have tips which are configured to provide the quantum point contacts. The tips may have widths in the range 25 to 15 nm, optionally 30 to 40 nm. The use of quantum point contacts may avoid changes to the electrostatic properties of the channel.

The leads are arranged to the side of the elongate strip. The leads may extend perpendicular to the elongate strip.

In another aspect, the present invention provides a method of operating a semiconductor-superconductor hybrid device as described herein, according to claim 14. The method comprises: cooling the device to a temperature at which the superconductor component is superconductive; applying gate voltages to the set of depletion gates to define the channel region by depleting charge carriers from regions of the semiconductor component around the perimeter of the channel region; applying a magnetic field to at least the channel region of the semiconductor component; and applying gate voltages to the helper gates to connect electrically the channel region to the leads.

Applying the gate voltages to the set of depletion gates may comprise tuning the outer segments to trivial regimes, and tuning the inner segment to a topological regime.

The method may further comprise measuring a current through the leads. A non-local conductance through the channel region may be derived based on such measurements.

In implementations where regions of the semiconductor component are to act as the leads, applying the gate voltages to the helper gate causes these regions to behave as conductors.

Other variants or use cases of the disclosed techniques may become apparent to the person skilled in the art once given the invention herein. The scope of the invention is not limited by the described embodiments but only by the accompanying claims.

**Claims**

1. A semiconductor-superconductor hybrid device (200), comprising:

    a semiconductor component (220) configured to host a 2-dimensional electron gas or a 2-dimensional hole gas;
    a superconductor component (230) arranged over the semiconductor component (220), the superconductor component (230) being capable of inducing superconductivity in a channel region (224a) of the semiconductor component (220) by proximity effect; and
    a set of depletion gates (252, 254, 256) arranged over the semiconductor component (220), the set of depletion gates (252, 254, 256) being configured to define boundaries of the channel region (224a) by depleting charge carriers from regions of the semiconductor component along edges of the channel region (224a);

wherein the superconductor component (230) comprises an elongate strip of superconductor material having two ends, at least one of the ends being electrically grounded;

wherein the set of depletion gates (252, 254, 256) comprises:

at least one first outer depletion gate (252) for defining a first outer segment of the channel region (224a);
at least one second outer depletion gate (256) for defining a second outer segment of the channel region (224a); and
at least one inner depletion gate (254) for defining an inner segment of the channel region (224a) between the first outer segment and the second inner segment;

wherein the semiconductor-superconductor hybrid device (200) further comprises:

a first junction comprising a first space between the at least one first outer depletion gate (252) and the at least one inner depletion gate (254), and a first helper gate (270a) for gating the first space;
a second junction comprising a second space between the at least one second outer depletion gate (256) and the at least one inner depletion gate (254), and a second helper gate (270b) for gating the second space; and

wherein the first and second helper gates (270a, 270b) are each operable to connect electrically the channel region (224a) to respective leads.

2. The semiconductor-superconductor hybrid device according to claim 1, wherein:

the first and second outer depletion gates (252, 256) are configured to tune the outer segments to trivial regimes;
the at least one inner depletion gate (254) is configured to tune the inner segment to a topological regime.

3. The semiconductor-superconductor hybrid device according to claim 1 or claim 2, wherein:

the first outer segment and the second outer segment each have lengths which are greater than or equal to a maximum superconducting coherence length of the semiconductor-superconductor hybrid device (200); and/or
the first and second outer segments each have lengths of at least 2 $\mu$m.

4. The semiconductor-superconductor hybrid device according to any preceding claim, wherein:

both ends of the superconductor component (230) are electrically grounded; and/or
the superconductor component (230) consists essentially of the elongate strip; and/or
the elongate strip is unbranched.

5. The semiconductor-superconductor hybrid device according to any preceding claim, further comprising a dielectric (240) arranged between the set of depletion gates (252, 254, 256) and the superconductor component (230); optionally wherein at least one of the depletion gates (252, 254, 256) extends over the superconductor component (230) such that the superconductor component (230) screens the inner segment from the inner depletion gate (254).

6. The semiconductor-superconductor hybrid device according to any preceding claim, wherein the at least one inner depletion gate is a single depletion gate (254).

7. The semiconductor-superconductor hybrid device according to any of claims 1 to 5, wherein the at least one inner depletion gate is a pair of opposed depletion gates (454a, 454b), each depletion gate of the pair of opposed depletion gates (454a, 454b) being arranged along a respective edge of the inner segment.

8. The semiconductor-superconductor hybrid device according to any preceding claim, wherein the first and second outer depletion gates are each pairs of opposed depletion gates.

9. The semiconductor-superconductor hybrid device according to claim 7 or claim 8, wherein:
a space between two adjacent depletion gates (452a, 454a) on a first side of the channel region (224a) is laterally offset from a space between two adjacent depletion gates (452b, 454b) on a second side of the channel region opposite the first side.

10. The semiconductor-superconductor hybrid device according to any preceding claim, wherein:

the leads are regions of the semiconductor component (220), the helper gates (270a, 270b) being configured to tune the leads to a normally-conductive state; or
the leads are metal leads (472a, 472b).

11. The semiconductor-superconductor hybrid device according to any preceding claim, wherein the leads extend perpendicular to the elongate strip.

12. The semiconductor-superconductor hybrid device according to any preceding claim, wherein the semiconductor component (220) is a heterostructure comprising a quantum well (224) arranged between lower and upper barriers (222, 226).

13. The semiconductor-superconductor hybrid device according to any preceding claim, wherein the helper gates (570) have respective tips configured to provide quantum point contacts between the channel region (224a) and the leads.

14. A method of operating the semiconductor-superconductor hybrid device according to any preceding claim, which method comprises:

cooling (1001) the semiconductor-superconductor hybrid device to a temperature at which the superconductor component (230) is superconductive;
applying (1002) gate voltages to the set of depletion gates (252, 254, 256) to define the channel region (224a) by depleting charge carriers from regions of the semiconductor component (220) along edges of the channel region (224a);
applying (1003) a magnetic field to at least the channel region (224a) of the semiconductor component (220); and
applying (1004) gate voltages to the helper gates (270a, 270b) to connect electrically the channel region (224a) to the leads;
optionally wherein the method further comprises measuring a current through the leads.

15. The method according to claim 14, wherein:

applying (1002) the gate voltages to the set of depletion gates (252, 254, 256) comprises tuning the outer segments to trivial regimes, and tuning the inner segment to a topological regime; and/or
the leads are regions of the semiconductor component (220) which are caused to be conductive by applying the gate voltages to the helper gates (270a, 270b).

**Patentansprüche**

1. Halbleiter-Supraleiter-Hybridbauelement (200), umfassend:

eine Halbleiterkomponente (220), die konfiguriert ist, um ein zweidimensionales Elektronengas oder ein zweidimensionales Lochgas aufzunehmen;
eine Supraleiterkomponente (230), die über der Halbleiterkomponente (220) angeordnet ist, wobei die Supraleiterkomponente (230) in der Lage ist, durch Proximity-Effekt Supraleitung in einem Kanalbereich (224a) der Halbleiterkomponente (220) zu induzieren; und
einen Satz von Verarmungsgates (252, 254, 256), die über der Halbleiterkomponente (220) angeordnet sind, wobei der Satz von Verarmungsgates(252, 254, 256) konfiguriert ist, um Grenzen des Kanalbereichs (224a) zu definieren, indem Ladungsträger aus Bereichen der Halbleiterkomponente entlang von Kanten des Kanalbereichs (224a) verarmt werden;
wobei die Supraleiterkomponente (230) einen länglichen Streifen aus Supraleitermaterial mit zwei Enden umfasst, wobei mindestens eines der Enden elektrisch geerdet ist;
wobei der Satz von Verarmungsgates (252, 254, 256) Folgendes umfasst:

mindestens ein erstes äußeres Verarmungsgate (252) zum Definieren eines ersten äußeren Segments des Kanalbereichs (224a);
mindestens ein zweites äußeres Verarmungsgate (256) zum Definieren eines zweiten äußeren Segments des Kanalbereichs (224a); und
mindestens ein inneres Verarmungsgate (254) zum Definieren eines inneren Segments des Kanalbereichs (224a) zwischen dem ersten äußeren Segment und dem zweiten inneren Segment;

wobei das Halbleiter-Supraleiter-Hybridbauelement (200) ferner Folgendes umfasst:

einen ersten Übergang, der einen ersten Raum zwischen dem mindestens einen ersten äußeren Verarmungsgate (252) und dem mindestens einen inneren Verarmungsgate (254) und ein erstes Hilfsgate (270a) zum Gaten des ersten Raums umfasst;
einen zweiten Übergang, der einen zweiten Raum zwischen dem mindestens einen zweiten äußeren Verarmungsgate (256) und dem mindestens einen inneren Verarmungsgate (254) und ein zweites Hilfsgate (270b) zum Gaten des zweiten Raums umfasst; und

wobei das erste und das zweite Hilfsgate (270a, 270b) jeweils dazu geeignet sind, den Kanalbereich (224a) elektrisch mit jeweiligen Leitungen zu verbinden.

2. Halbleiter-Supraleiter-Hybridbauelement nach Anspruch 1, wobei:

das erste und das zweite äußere Verarmungsgate (252, 256) konfiguriert sind, um die äußeren Segmente auf triviale Bereiche abstimmen;
das mindestens eine innere Verarmungsgate (254) konfiguriert, um das innere Segment auf einen topologischen Bereich abzustimmen.

3. Halbleiter-Supraleiter-Hybridbauelement nach Anspruch 1 oder Anspruch 2, wobei:

das erste äußere Segment und das zweite äußere Segment jeweils Längen aufweisen, die größer oder gleich einer maximalen supraleitenden Kohärenzlänge des Halbleiter-Supraleiter-Hybridbauelements (200) sind; und/oder
das erste und das zweite äußere Segment jeweils eine Länge von mindestens 2 $\mu$m aufweisen.

4. Halbleiter-Supraleiter-Hybridbauelement nach einem der vorhergehenden Ansprüche, wobei:

beide Enden der Supraleiterkomponente (230) elektrisch geerdet sind; und/oder
die Supraleiterkomponente (230) im Wesentlichen aus dem länglichen Streifen besteht; und/oder
der längliche Streifen unverzweigt ist.

5. Halbleiter-Supraleiter-Hybridbauelement nach einem der vorhergehenden Ansprüche, das außerdem ein Dielektrikum (240) umfasst, das zwischen der Gruppe von Verarmungsgates (252, 254, 256) und der Supraleiterkomponente (230) angeordnet ist;
wobei gegebenenfalls mindestens eines der Verarmungsgates (252, 254, 256) sich über die Supraleiterkomponente (230) erstreckt, sodass die Supraleiterkomponente (230) das innere Segment vom inneren Verarmungsgate (254) abschirmt.

6. Halbleiter-Supraleiter-Hybridbauelement nach einem der vorhergehenden Ansprüche, wobei das mindestens eine innere Verarmungsgate ein einzelnes Verarmungsgate (254) ist.

7. Halbleiter-Supraleiter-Hybridbauelement nach einem der Ansprüche 1 bis 5, wobei das mindestens eine innere Verarmungsgate ein Paar gegenüberliegender Verarmungsgates (454a, 454b) ist, wobei jedes Verarmungsgate des Paars gegenüberliegender Verarmungsgates (454a, 454b) entlang einer jeweiligen Kante des inneren Segments angeordnet ist.

8. Halbleiter-Supraleiter-Hybridbauelement nach einem der vorhergehenden Ansprüche, wobei das erste und das zweite äußere Verarmungsgate jeweils Paare gegenüberliegender Verarmungsgates sind.

9. Halbleiter-Supraleiter-Hybridbauelement nach Anspruch 7 oder Anspruch 8, wobei:
ein Raum zwischen zwei benachbarten Verarmungsgates (452a, 454a) auf einer ersten Seite des Kanalbereichs (224a) seitlich versetzt zu einem Raum zwischen zwei benachbarten Verarmungsgates (452b, 454b) auf einer der ersten Seite gegenüberliegenden zweiten Seite des Kanalbereichs ist.

10. Halbleiter-Supraleiter-Hybridbauelement nach einem der vorhergehenden Ansprüche, wobei:

die Leitungen Bereiche der Halbleiterkomponente (220) sind, wobei die Hilfsgates (270a, 270b) konfiguriert sind, um die Leitungen in einen normalleitenden Zustand zu versetzen; oder
die Leitungen Metallleitungen (472a, 472b) sind.

11. Halbleiter-Supraleiter-Hybridbauelement nach einem der vorhergehenden Ansprüche, wobei die Leitungen senkrecht zum länglichen Streifen verlaufen.

12. Halbleiter-Supraleiter-Hybridbauelement nach einem der vorhergehenden Ansprüche, wobei die Halbleiterkomponente (220) eine Heterostruktur ist, die einen zwischen unteren und oberen Barrieren (222, 226) angeordneten Quantentopf (224) umfasst.

13. Halbleiter-Supraleiter-Hybridbauelement nach einem der vorhergehenden Ansprüche, wobei die Hilfsgates (570) jeweilige Spitzen aufweisen, die konfiguriert sind, um Quantenpunktkontakte zwischen dem Kanalbereich (224a) und den Leitungen bereitzustellen.

14. Verfahren zum Betreiben des Halbleiter-Supraleiter-Hybridbauelements nach einem der vorhergehenden Ansprüche, umfassend:

Abkühlen (1001) des Halbleiter-Supraleiter-Hybridbauelements auf eine Temperatur, bei der die Supraleiterkomponente (230) supraleitend ist;
Anlegen (1002) von Gate-Spannungen an die Gruppe von Verarmungsgates (252, 254, 256), um den Kanalbereich (224a) durch Verarmung von Ladungsträgern aus Bereichen der Halbleiterkomponente (220) entlang der Kanten des Kanalbereichs (224a) zu definieren;
Anlegen (1003) eines Magnetfelds an mindestens den Kanalbereich (224a) der Halbleiterkomponente (220); und
Anlegen (1004) von Gate-Spannungen an die Hilfsgates (270a, 270b), um den Kanalbereich (224a) elektrisch mit den Leitungen zu verbinden;
wobei das Verfahren gegebenenfalls ferner das Messen eines Stroms durch die Leitungen umfasst.

15. Verfahren nach Anspruch 14, wobei:

das Anlegen (1002) der Gate-Spannungen an den Satz von Verarmungsgates (252, 254, 256) das Einstellen der äußeren Segmente auf triviale Bereiche umfasst und das Einstellen des inneren Segments auf einen topologischen Bereich umfasst; und/oder
die Leitungen Bereiche der Halbleiterkomponente (220) sind, die durch Anlegen der Gate-Spannungen an die Hilfsgates (270a, 270b) leitfähig gemacht werden.

**Revendications**

1. Dispositif hybride semi-conducteur-supraconducteur (200), comprenant :

un composant semi-conducteur (220) configuré pour héberger un gaz d'électrons bidimensionnel ou un gaz de trous bidimensionnel ;
un composant supraconducteur (230) disposé au-dessus du composant semi-conducteur (220), le composant supraconducteur (230) étant susceptible d'induire une supraconductivité dans une région de canal (224a) du composant semi-conducteur (220) par effet de proximité ; et
un ensemble de grilles d'appauvrissement (252, 254, 256) disposé au-dessus du composant semi-conducteur (220), l'ensemble de grilles d'appauvrissement (252, 254, 256) étant configuré pour définir les limites de la région de canal (224a) en appauvrissant les porteurs de charge de régions du composant semi-conducteur le long de bords de la région de canal (224a) ;
dans lequel le composant supraconducteur (230) comprend une bande allongée de matériau supraconducteur ayant deux extrémités, au moins une des extrémités étant mise à la terre électriquement ;
dans lequel l'ensemble de grilles d'appauvrissement (252, 254, 256) comprend :

au moins une première grille d'appauvrissement externe (252) pour définir un premier segment externe de la région de canal (224a) ;
au moins une seconde grille d'appauvrissement externe (256) pour définir un second segment externe de la région de canal (224a) ; et
au moins une grille d'appauvrissement interne (254) pour définir un segment interne de la région de canal (224a) entre le premier segment externe et le second segment interne ;
dans lequel le dispositif hybride semi-conducteur-supraconducteur (200) comprend en outre :

une première jonction comprenant un premier espace entre l'au moins une première grille d'appauvrissement externe (252) et l'au moins une grille d'appauvrissement interne (254), et une première grille auxiliaire (270a) pour bloquer le premier espace ;
une seconde jonction comprenant un second espace entre l'au moins une seconde grille d'appauvrissement externes (256) et l'au moins une grille d'appauvrissement interne (254), et une seconde grille auxiliaire (270b) pour bloquer le second espace ; et

dans lequel les première et seconde grilles auxiliaires (270a, 270b) sont chacune opérationnelles pour connecter électriquement la région de canal (224a) à des conducteurs respectifs.

2. Dispositif hybride semi-conducteur-supraconducteur selon la revendication 1, dans lequel :

les première et seconde portes d'appauvrissement externes (252, 256) sont configurées pour accorder les segments externes sur des régimes triviaux ;
l'au moins une porte d'appauvrissement interne (254) est configurée pour accorder le segment interne sur un régime topologique.

3. Dispositif hybride semi-conducteur-supraconducteur selon la revendication 1 ou la revendication 2, dans lequel :

le premier segment externe et le second segment externe ont chacun des longueurs qui sont supérieures ou égales à une longueur de cohérence supraconductrice maximale du dispositif hybride semi-conducteur-supraconducteur (200) ; et/ou
les premier et second segments externes ont chacun des longueurs d'au moins 2 μm.

4. Dispositif hybride semi-conducteur-supraconducteur selon une quelconque revendication précédente, dans lequel :

les deux extrémités du composant supraconducteur (230) sont mises à la terre électriquement ; et/ou
le composant supraconducteur (230) est constitué essentiellement de la bande allongée ; et/ou
la bande allongée n'est pas ramifiée.

5. Dispositif hybride semi-conducteur-supraconducteur selon une quelconque revendication précédente, comprenant en outre un diélectrique (240) disposé entre l'ensemble de grilles d'appauvrissement (252, 254, 256) et le composant supraconducteur (230) ;
éventuellement dans lequel au moins une des portes d'appauvrissement (252, 254, 256) s'étend au-dessus du composant supraconducteur (230) de telle sorte que le composant supraconducteur (230) protège le segment interne de la porte d'appauvrissement interne (254).

6. Dispositif hybride semi-conducteur-supraconducteur selon une quelconque revendication précédente, dans lequel l'au moins une grille d'appauvrissement interne est une grille d'appauvrissement unique (254).

7. Dispositif hybride semi-conducteur-supraconducteur selon une quelconque des revendications 1 à 5, dans lequel l'au moins une grille d'appauvrissement interne est une paire de grilles d'appauvrissement opposées (454a, 454b), chaque grille d'appauvrissement de la paire de grilles d'appauvrissement opposées (454a, 454b) étant disposée le long d'un bord respectif du segment interne.

8. Dispositif hybride semi-conducteur-supraconducteur selon une quelconque revendication précédente, dans lequel les première et seconde grilles d'appauvrissement externes sont chacune des paires de grilles d'appauvrissement opposées.

9. Dispositif hybride semi-conducteur-supraconducteur selon la revendication 7 ou la revendication 8, dans lequel :
un espace entre deux grilles d'appauvrissement (452a, 454a) adjacentes sur un premier côté de la région de canal (224a) est décalé latéralement d'un espace entre deux grilles d'appauvrissement (452b, 454b) adjacentes sur un second côté de la région de canal opposé au premier côté.

10. Dispositif hybride semi-conducteur-supraconducteur selon une quelconque revendication précédente, dans lequel :

les conducteurs sont des régions du composant semi-conducteur (220), les grilles auxiliaires (270a, 270b) étant configurées pour accorder les conducteurs sur un état normalement conducteur; ou
les conducteurs sont des conducteurs métalliques (472a, 472b).

11. Dispositif hybride semi-conducteur-supraconducteur selon une quelconque revendication précédente, dans lequel les conducteurs s'étendent perpendiculairement à la bande allongée.

12. Dispositif hybride semi-conducteur-supraconducteur selon une quelconque revendication précédente, dans lequel le composant semi-conducteur (220) est une hétérostructure comprenant un puits quantique (224) disposé entre des barrières inférieure et supérieure (222, 226).

13. Dispositif hybride semi-conducteur-supraconducteur selon une quelconque revendication précédente, dans lequel les grilles auxiliaires (570) ont des pointes respectives configurées pour fournir des contacts de points quantiques entre la région de canal (224a) et les conducteurs.

14. Procédé de fonctionnement du dispositif hybride semi-conducteur-supraconducteur selon une quelconque revendication précédente, lequel procédé comprend :

le refroidissement (1001) du dispositif hybride semi-conducteur-supraconducteur à une température à laquelle le composant supraconducteur (230) est supraconducteur ;
l'application (1002) de tensions de grille à l'ensemble de grilles d'appauvrissement (252, 254, 256) pour définir la région de canal (224a) en appauvrissant les porteurs de charge de régions du composant semi-conducteur (220) le long de bords de la région de canal (224a) ;
l'application (1003) d'un champ magnétique à au moins la région de canal (224a) du composant semi-conducteur (220) ; et
l'application (1004) de tensions de grille aux grilles auxiliaires (270a, 270b) pour connecter électriquement la région de canal (224a) aux conducteurs ;
éventuellement dans lequel le procédé comprend en outre la mesure d'un courant à travers les conducteurs.

15. Procédé selon la revendication 14, dans lequel :

l'application (1002) des tensions de grille à l'ensemble de grilles d'appauvrissement (252, 254, 256) comprend l'accord des segments externes sur des régimes triviaux, et l'accord du segment interne sur un régime topologique ; et/ou
les conducteurs sont des régions du composant semi-conducteur (220) qui sont rendues conductrices par l'application des tensions de grille aux grilles auxiliaires (270a, 270b).

Fig. 1

EP 4 381 919 B1

Fig. 2

200

254

230

240

226

224

224a

222

220

210

Fig. 3

Fig. 4

EP 4 381 919 B1

Fig. 5

Fig. 6

Fig. 7

Fig. 8

Fig. 9

1001 — Cooling the device to a temperature at which the superconductor component is superconductive.

1002 — Applying gate voltages to the set of depletion gates to define the active region by depleting charge carriers from boundaries of the active region.

1003 — Applying a magnetic field to at least the channel region.

1004 — Applying gate voltages to the helper gates.

Fig. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2019001753 A1
- US 2021126181 A1

### Non-patent literature cited in the description

- **HART et al.** *Nature Physics*, 2014, vol. 10, 638-643
- **JOUAN et al.** *arXiv: 1903.12134v1*
- **ODOH** ; **NJAPBA**. A Review of Semiconductor Quantum Well Devices. *Advances in Physics Theories and Applications*, 2015, vol. 46, 26-32
- Springer Handbook of Electronic and Photonic Materials